Europäisches Patentamt

European Patent Office

Office européen des brevets

(11) Veröffentlichungsnummer: **0 306 741**
**A2**

(12) **EUROPÄISCHE PATENTANMELDUNG**

(21) Anmeldenummer: **88113359.9**

(22) Anmeldetag: **17.08.88**

(51) Int. Cl.4: **G01R 1/073 , H01R 13/62**

(30) Priorität: **24.08.87 DE 8711463 U**

(43) Veröffentlichungstag der Anmeldung:
**15.03.89 Patentblatt 89/11**

(84) Benannte Vertragsstaaten:
**BE DE FR GB IT NL**

(71) Anmelder: **Siemens Aktiengesellschaft Berlin
und München
Wittelsbacherplatz 2
D-8000 München 2(DE)**

(72) Erfinder: **Dittrich, Josef, Dipl.-Ing.
Seegasse 26
D-7500 Karlsruhe 41(DE)**

(54) **Elektrische Leiterplatten-Kontaktiereinrichtung.**

(57) Bei einer elektrischen Leiterplatten-Kontaktiereinrichtung mit Kontaktnadeln (1), die elektrisch mit
einer Prüfelektronik verbunden und an die Leiterbahnen eines Prüflings (4) andrückbar sind, ist zur genauen und sicheren Kontaktierung der Kontaktnadeln
(1) eine magnetische Andrückvorrichtung vorhanden,
welche die magnetischen Kontaktnadeln (1) an die
zu kontaktierenden Leiterbahnen andrückt. Die magnetische Kraft wirkt immer durch den nichtmagnetischen Prüfling (4) hindurch.

Die Erfindung ist vor allem bei Prüfvorgängen in
der Leiterplattenherstellung anwendbar.

FIG 1

EP 0 306 741 A2

## Elektrische Leiterplatten-Kontaktiereinrichtung

### Technisches Gebiet

Die Erfindung betrifft eine Leiterplatten-Kontaktiereinrichtung gemäß dem Oberbegriff des Anspruchs 1. Es sollen zur elektrischen Prüfung der Kontaktierungspunkte und Verbindungsleitungen auf den zu prüfenden Leiterplatten in einem Prüfsystem für diese Kontaktierungspunkte elektrische Größen stimuliert und gemessen werden.

### Stand der Technik

Aus der DE-OS 29 18 948 ist eine Kontaktiereinrichtung dieser Art bekannt, bei der mit einer Feldwicklung ein Magnetfeld erzeugt wird und derart auf die Halterung einer Kontaktnadel einwirkt, daß diese Kontaktnadel mechanisch an die zu prüfende Leiterplatte angedrückt wird.

### Darstellung der Erfindung

Der Erfindung liegt die Aufgabe zugrunde, eine genaue und sichere Kontaktierung der zu prüfenden Punkte auf den Leiterplatten auch bei völlig rasterfreien oder im Raster liegenden, auch sehr unebenen und extrem eng angeordneten Kontaktierungspunkten mit einfachen Mitteln zu gewährleisten.

Zur Lösung der gestellten Aufgabe sind bei einer Leiterplatten- Kontaktiereinrichtung die kennzeichnenden Merkmale des Anspruchs 1 vorhanden.

Die erfindungsgemäße Lösung stellt eine vorteilhafte Weiterentwicklung der bekannten Leiterplatten-Kontaktierungen dar, indem die Kontaktnadeln nicht über mechanische, hydraulische oder pneumatische Kräfte - selbst bei indirekter Wirkung einer magnetischen Kraft -, sondern direkt im Verlauf der magneti schen Kraftlinien nach dem Prinzip eines sogenannten Reed-Relais unmittelbar an die Prüflinge angedrückt werden.

Vorteilhafte Ausführungsbeispiele sind mit den Unteransprüchen angegeben.

Die Kontaktierungsnadeln sind in vorteilhafter Weise aus hart- oder weichmagnetischem Material. Diese sind an dem vom Prüfling wegzeigenden Ende über flexible Leitungen mit der Prüfelektronik im Prüfsystem verbunden. Diese Anordnung gestattet rastergebundene, rasterfreie oder gemischte Kontaktierungen von Prüflingen bis zu extrem kleinen Prüfpunktabständen. Die Anzahl der Kontaktierungsnadeln und der dazugehörigen Prüfelektronik kann auf die maximale Anschlußpunkteanzahl eines Prüflings begrenzt werden.

Bei rasterfreier Kontaktierung muß eine Zuordnung der Durchschalteadressen der Prüfeinrichtung zu den X/Y-Koordinaten des Prüflings gefunden werden. Diese Zuordnung kann durch Lernprüfläufe mit geeignet gemusterten Prüflingen erfolgen. Ein nachfolgend laufendes Sortierprogramm ordnet jedem Prüfpunkt seine X/Y-Koordinaten zu. Hiernach wiederum können diesen X/Y-Koordinaten prüflingsspezifische Bezeichnungen zugeordnet werden.

### Kurze Beschreibung der Erfindung

Die Erfindung wird anhand der Figuren erläutert, wobei

Figur 1 das Kontaktierungsprinzip skizziert,

Figur 2 das Schnittbild einer beidseitigen Kontaktierung mit eingetragenem Verlauf des magnetischen Hauptflusses und den Ort der elektromagnetischen Kraftwirkung zeigt,

Figuren 3 und 4 sowie 13 und 14 Ausführungsbeispiele einer einseitigen Kontaktiereinrichtung sind,

Figuren 5 bis 12 und 15 bis 18 Ausführungsbeispiele beidseitiger Kontaktiereinrichtungen darstellen und

Figuren 19 bis 24 sechs verschiedene Formen von Kontaktnadeln mit ihren Querschnitten darstellen.

### Bester Weg zur Ausführung der Erfindung

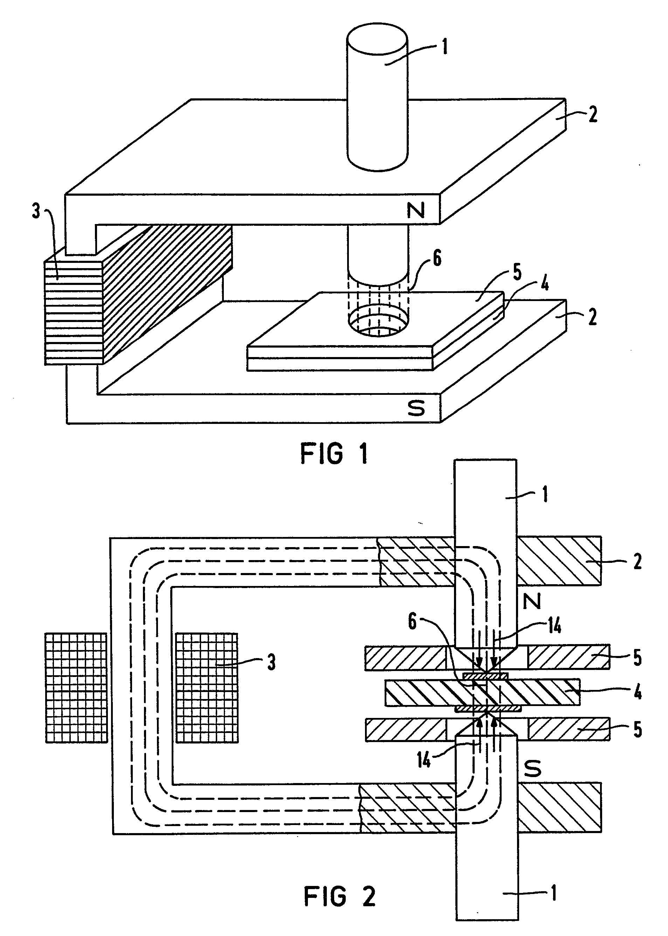

In der Figur 1 ist das Adaptionsprinzip einer elektrischen Leiterplatten-Kontaktiereinrichtung dargestellt, bei der eine Kontaktnadel 1 in einer Flußleitschiene 2 beweglich gehalten ist. Durch das in einer Magnetspule 3 erzeugte Magnetfeld kann ein Prüfling 4 von der Kontaktnadel 1 durch eine Prüflingsmaske 5 kontaktiert werden. Die Kontaktnadel 1 bewegt sich dazu im Nutzmagnetfeld eines magnetischen Flusses 6, wobei der magnetische Fluß 6 außerdem noch ein Streumagnetfeld außerhalb des Bewegungsbereichs der Kontaktnadel 1 erzeugt.

Das Schnittbild nach der Figur 2 zeigt deutlich, wie der Andruck der Kontaktnadel 1 an den Prüfling 4 durch einen magnetischen Fluß 6 bewirkt wird, der durch den Prüfling 4 hindurchfließt. Diese Anordnung entspricht im wesentlichen der Darstellung nach der Figur 1. Unterschiedlich ist hier nur, daß eine beidseitige Kontaktierung des Prüflings 4 durch zwei Prüflingsmasken 5 und zwei Kontaktnadeln 1 vorgenommen wird. Die Kraftwirkung, die die Kontaktnadeln 1 an den Prüfling 4 andrückt, ist durch Pfeile 14 gekennzeichnet.

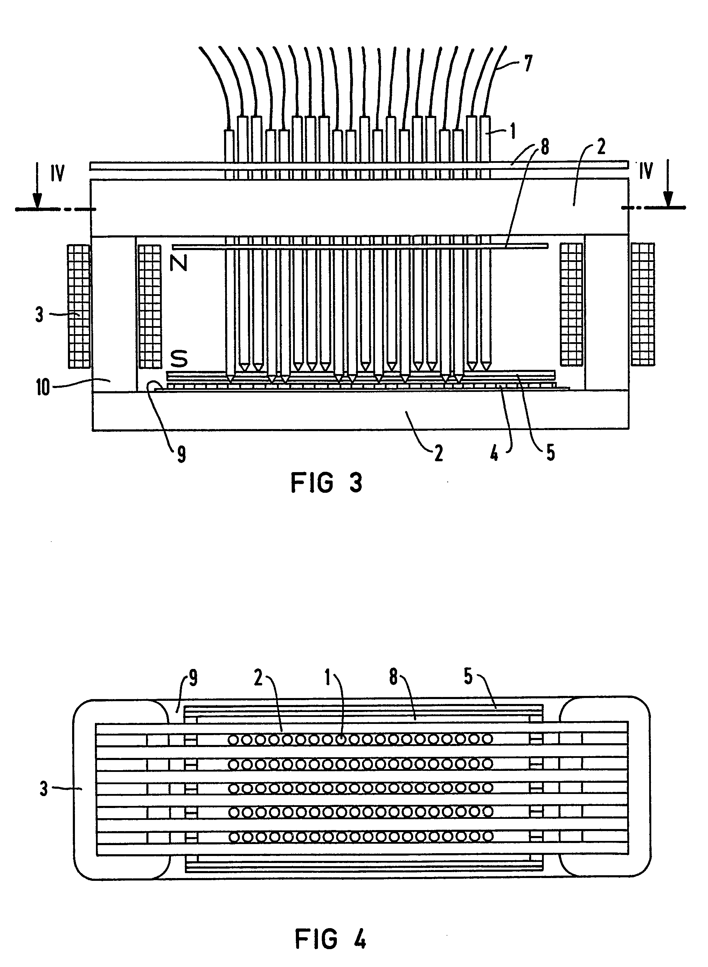

Die Kontaktiereinrichtung nach Figur 3 zeigt ein Ausführungsbeispiel mit einer großen Anzahl von Kontaktnadeln 1, die jeweils mit Leitungen 7 versehen sind, die zu der hier nicht dargestellten Meßelektronik führen. In Abwandlung zu den vorherigen Darstellungen sind zusätzlich noch Lochrasterplatten oder Lochrasterfolien 8 vorhanden, in denen die für den jeweiligen Prüfling spezifischen Kontaktnadeln 1 gehalten bzw. geführt werden. Der Prüfling 4 weist hier eine einseitige Kontaktierung auf und liegt mit der Rückseite auf einer Isolierfolie 9. An beiden Enden der Kontaktiereinrichtung ist ein Magnetkern 10 vorhanden, der von der Magnetspule 3 umgeben ist.

Ein Schnittbild durch die Schnittlinie A-A gemäß Figur 3 ist in der Figur 4 dargestellt. Die Kontaktnadeln 1 können bei dieser Anordnung entweder weich- oder hartmagnetisch sein. Die Magnetspulen 3 werden beim Prüfvorgang von Gleichstrom durch flossen, wobei beim Einschalten Wechselstrom überlagert sein kann, der die Kontaktnadeln 1 zum Vibrieren bringt und damit eine Oberflächenreinigung beim Prüfling und eine bessere Kontaktierung möglich macht. Durch einen beim Ausschalten überlagerten Wechselstrom werden die Kontaktnadeln 1 wieder entmagnetisiert, und die gesamte Kontaktiereinrichtung kann mechanisch geöffnet werden. Beim Schnitt nach der Figur 4 sind die Flußleitschienen 2 deutlicher zu erkennen, die den Fluß zwischen den beiden Magnetkernen 10 leiten, wobei eine elektrische Parallel- oder Serienschaltung der Magnetspulen 10 möglich ist.

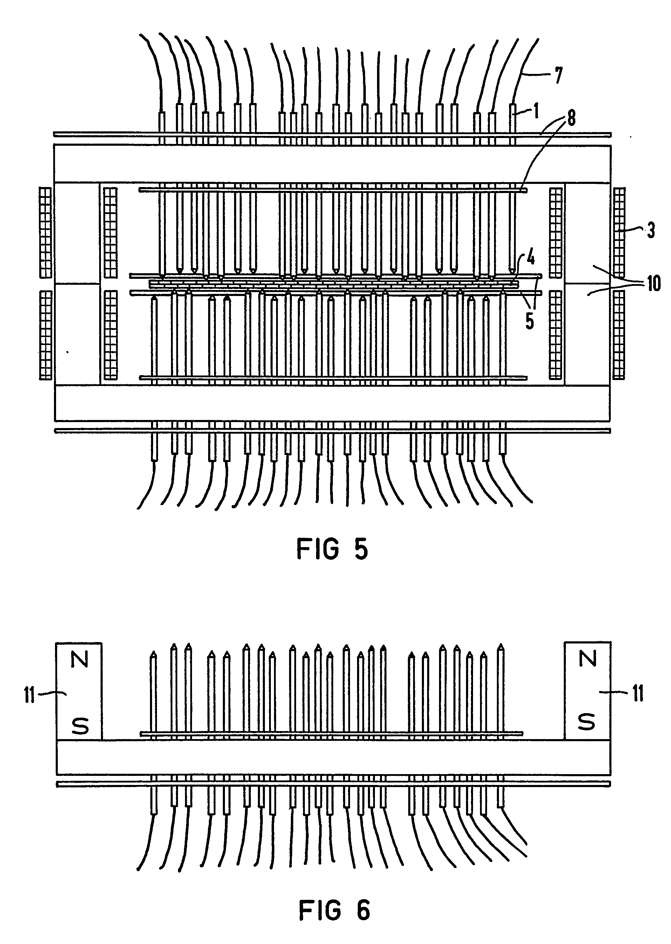

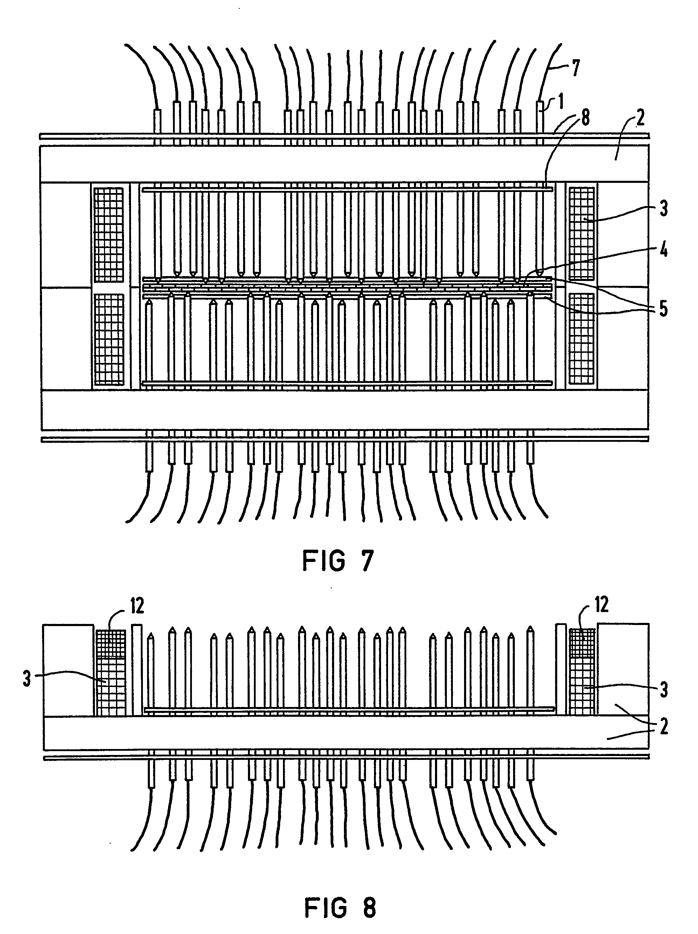

Das Ausführungsbeispiel nach der Figur 5 entspricht im wesentlichen dem Ausführungsbeispiel nach der Figur 3, jedoch ist hier ein Prüfling 4 mit beidseitiger Kontaktierung vorhanden, so daß auch eine doppelt ausgeführte Anordnung der Magnetkerne 10 mit den Magnetspulen 3 und der Kontaktnadel 1 mitsamt deren Halterung notwendig ist. Die Figur 6 entspricht dem mit Kontaktnadeln 1 versehenen unteren Teil der Figur 5, wobei hier jedoch Permanentmagnete 11 angeordnet sind, die dann jeweils mit einem elektrisch erregten Magneten der jeweils anderen Hälfte kombiniert werden. Das Öffnen der Kontaktiereinrichtung erfolgt hier durch Gegenpolen der Magnetfelder für die obere und die untere Hälfte der Kontaktiereinrichtung.

Das Ausführungsbeispiel nach der Figur 7 ist insofern von dem Ausführungsbeispiel nach der Figur 5 abgewandelt, daß hier Magnetspulen 3 die gesamte Kontaktiereinrichtung mitsamt den Kontaktnadeln 1 ringförmig umschließen. Bei der Abwandlung der unteren Hälfte der Kontaktiereinrichtung gemäß Figur 8 sind getrennte Wicklungen 12 für die Erzeugung eines Wechselfeldes vorhanden, das mit einer geeigneten Frequenz (beispielsweise 100 Hz bis Ultraschallbereich) zur Schwingungserzeugung der Kontaktnadeln 1 und damit zur besseren Kontaktierung dient.

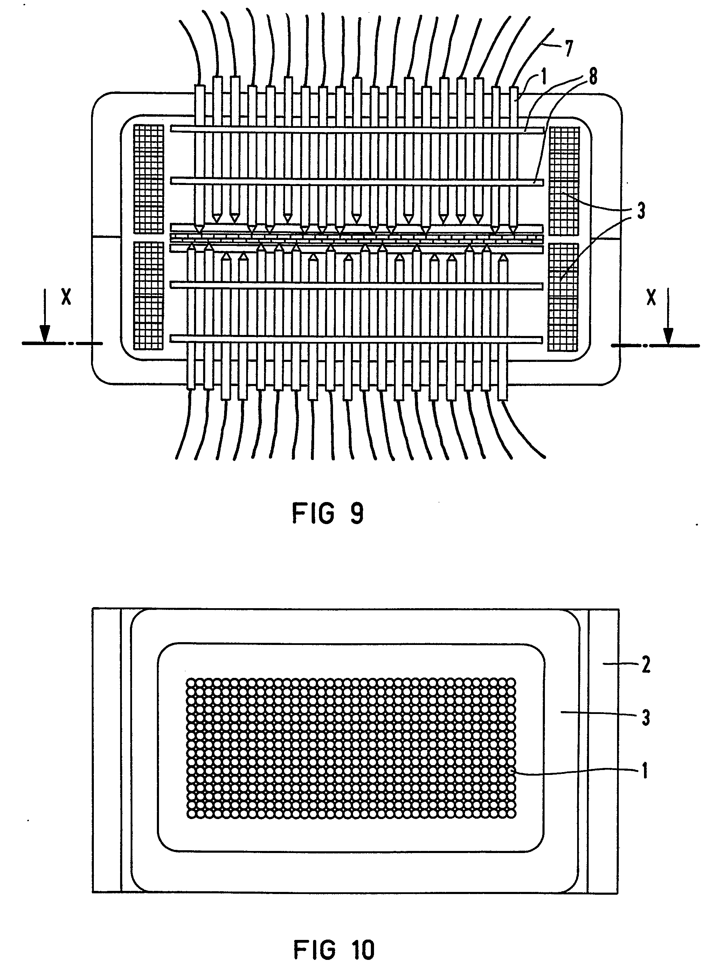

Das Ausführungsbeispiel nach der Figur 9 weist keine Flußleitschienen auf und bewirkt die Leitung des magnetischen Flusses über eine aus einem Blechpaket oder massiv hergestellte Lochrasterplatte 8 und weist wiederum Magnetwicklungen für jede Hälfte auf, die aus einer Anzahl von Teilwicklungen bestehen können, die parallel oder in Serie geschaltet sind. Zum besseren Verständnis ist das Ausführungsbeispiel nach der Figur 9 durch eine Schnittdarstellung im Schnitt A-A in der Figur 10 gezeigt.

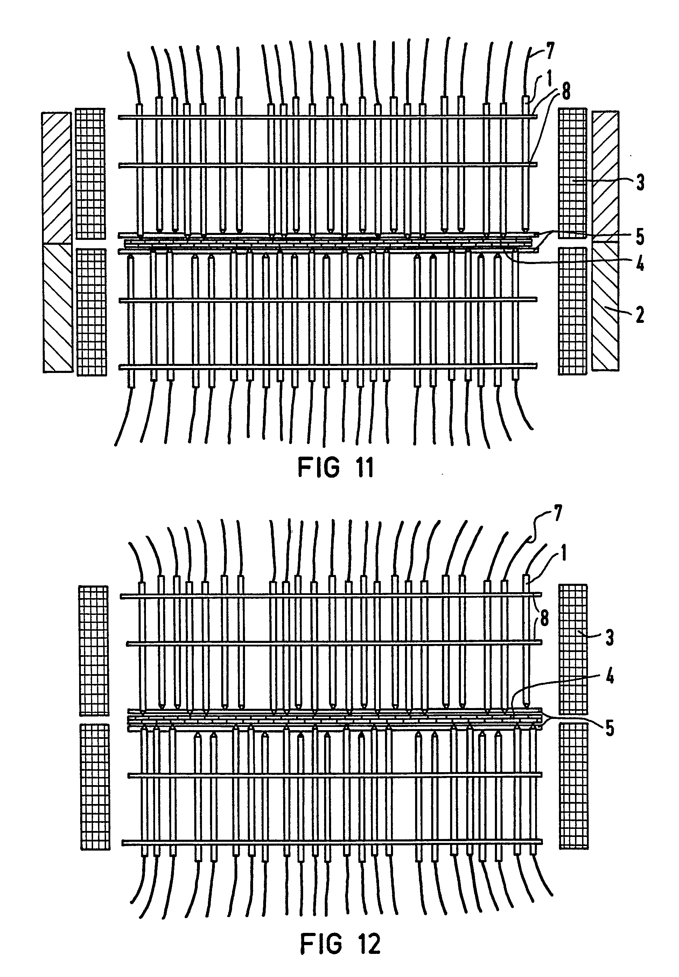

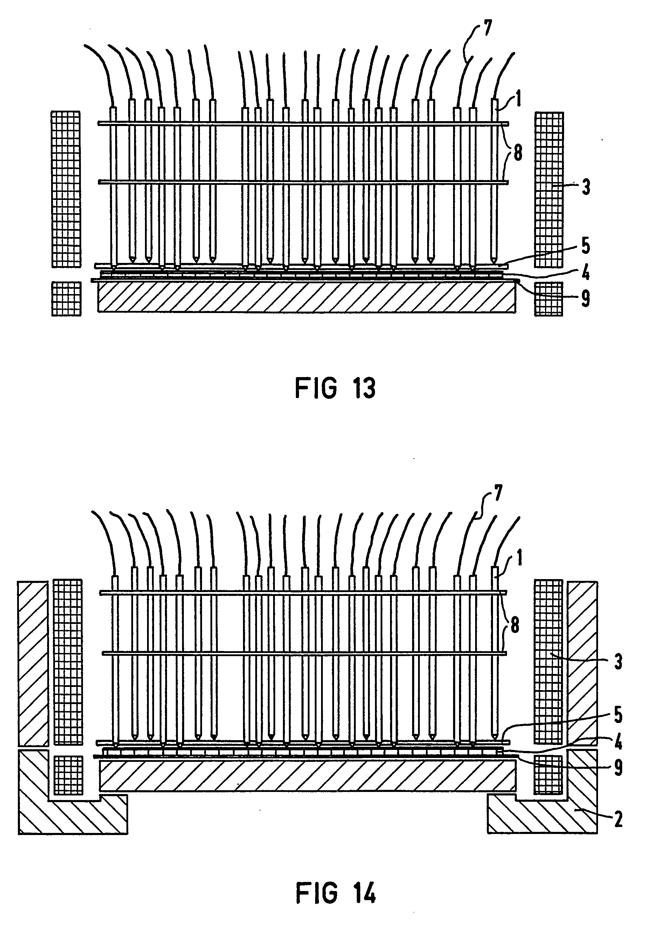

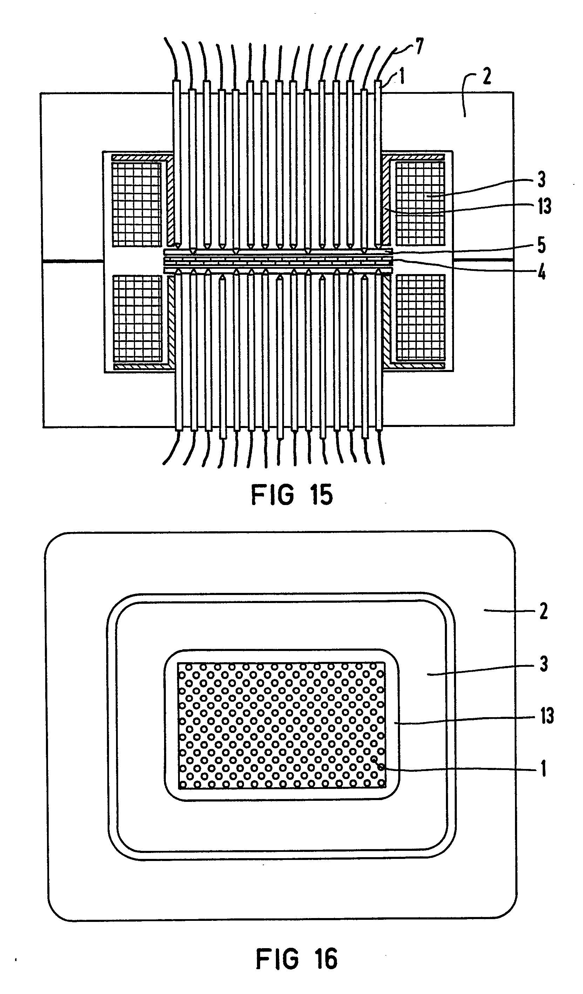

Das Ausführungsbeispiel nach der Figur 11 entspricht im wesentlichen dem Ausführungsbeispiel nach der Figur 7, jedoch fehlen hier sowohl die oberen wie die unteren Flußleitschienen; gemäß der Figur 12 sind die Flußleitschienen ganz entfernt. Figur 13 zeigt eine Abwandlung der Figur 7 für einseitige Kontaktierung des Prüflings 4 und die Figur 14 eine weitere Abwandlung der Figur 13 mit Flußleitschienen 2. Die Flußleitschiene gemäß den Figuren 13 und 14 kann beispielsweise auch durch eine permanentmagnetische Platte ersetzt werden.

Die Figuren 15 und 16 zeigen ein Ausführungsbeispiel einer Kontaktiereinrichtung für sehr kleine Kontaktabstände der Kontaktnadeln 1, wobei die Figur 16 ein Schnitt durch die Schnittlinie A-A in der Figur 15 ist. Die Verteilung des magnetischen Flusses 6 erfolgt hier über das Paket der Kontaktnadeln 1 direkt ohne besondere Flußleitschienen. Das Paket der Kontaktnadeln 1 befindet sich somit im Hauptfluß, so daß nur noch ein Nadelkäfig 13 zur Linearisierung des Randfeldes und zum Führen bzw. zum Zusammenhalten der Kontaktnadeln 1 notwendig ist.

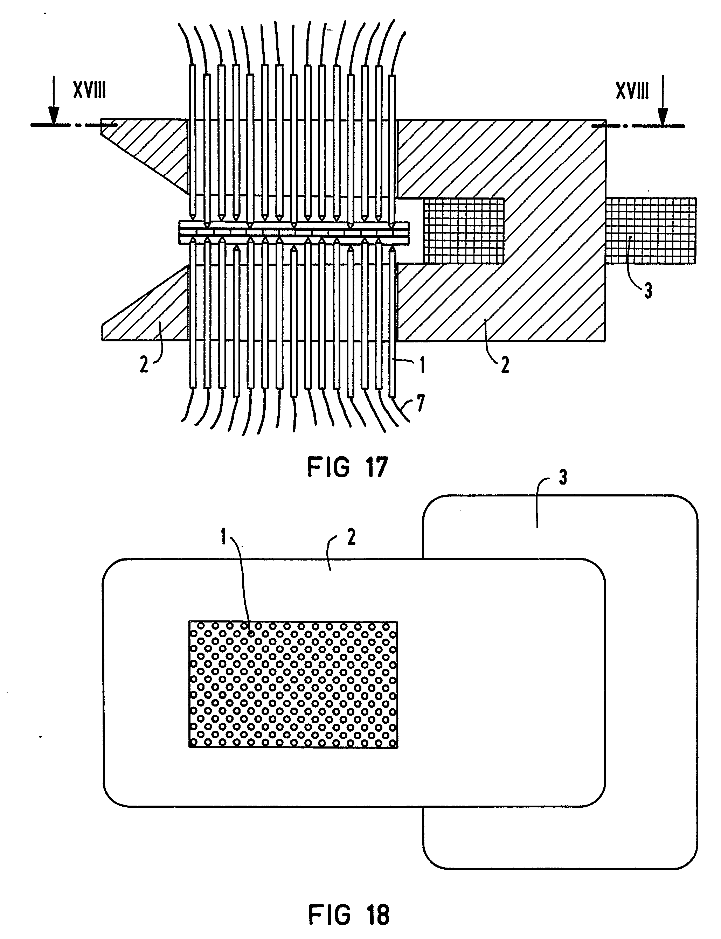

Für extrem kleine Kontaktabstände der Kontaktnadeln 1 ist das Ausführungsbeispiel gemäß den Figuren 17 und 18 geeignet, wobei die Figur 18 ein Schnitt durch die Schnittlinie A-A in der Figur 17 ist. Bei diesem Ausführungsbeispiel ist eine gute Zugänglichkeit der Kontaktnadeln und des Prüflings gewährleistet. Auf eine vollständige Flußführung ist hier ebenso wie bei dem Ausführungsbeispiel nach den Figuren 15 und 16 verzichtet.

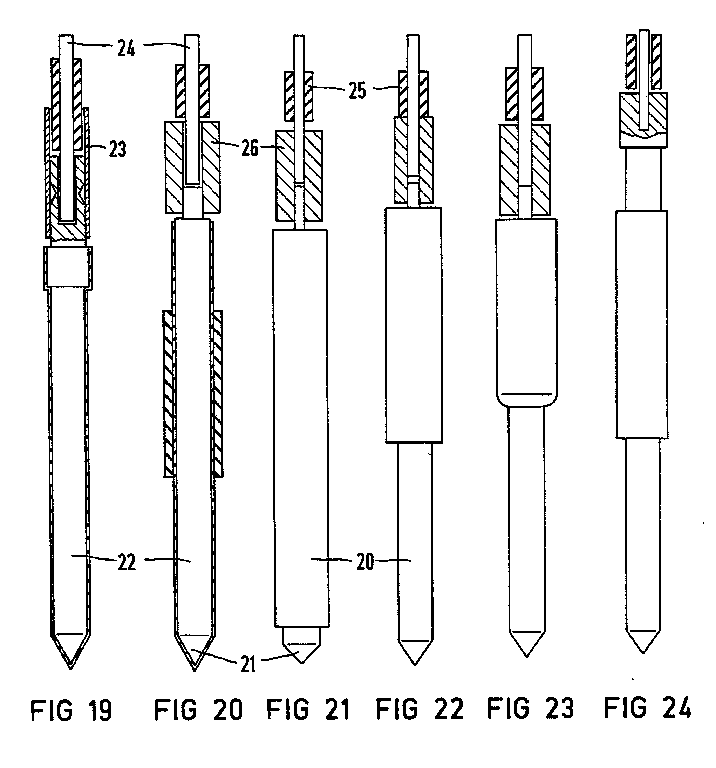

In den Figuren 19 und 20 sind Ausführungsbeispiele der Kontaktnadeln 1 mit jeweils verschiedenen Querschnitten dargestellt. An einem Nadelschaft 20 sind jeweils die Nadelköpfe 21, mit denen die Kontaktierung vorgenommen wird, gehalten. Eine Nadelisolierung 22 sorgt für eine Isolierung der Kontaktnadeln 1 von der Führung in der Kontaktiereinrichtung. Innerhalb eines Knickschutzschlauches 23 sind Kupferleitungen 24, die wiederum von einer Leitungsisolierung 25 umgeben sind, an die Kontaktnadeln 1 elektrisch verbindend angebracht. Bei den Ausführungsbeispielen 20 bis 24 sind noch gesonderte Verbindungsmittel 26 zwischen der Meßleitung 7 und den Kontaktnadeln 1 vorhanden. Die jeweiligen Querschnitte der Kontaktnadeln 1 sind jeweils unterhalb der Figuren dargestellt.

Gewerbliche Anwendbarkeit

Die Erfindung ist vor allem bei Prüfvorgängen in der Leiterplattenherstellung anwendbar.

**Ansprüche**

1. Elektrische Leiterplatten-Kontaktiereinrichtung
- mit Kontaktnadeln (1), die elektrisch mit einer Prüfelektronik verbunden und an die Leiterbahnen eines Prüflings (4) mittels magnetischer Kräfte andrückbar sind,
**dadurch gekennzeichnet, daß**
- die magnetische Kraftwirkung aufgrund eines magnetischen Feldes erzeugt ist, welches mit seinen Flußlinien über die magnetischen Kontaktnadeln (1) durch den nichtmagnetischen Prüfling (4) hindurchführt und die Kontaktnadeln (1) an die zu kontaktierenden Leiterbahnen andrückt.

2. Elektrische Leiterplatten-Kontaktiereinrichtung nach Anspruch 1, **dadurch gekennzeichnet, daß**
- ein Permanentmagnet (11) in der Kontaktiereinrichtung vorhanden ist, der je nach Polarität des elektromagnetischen Feldes von der anderen Adapterhälfte oder von den Kontaktnadeln (1) angezogen oder abgestoßen wird.

3. Elektrische Leiterplatten-Kontaktiereinrichtung nach Anspruch 1, **dadurch gekennzeichnet, daß**
- die Kontaktnadeln (1) durch ein magnetisches Wechselfeld geeigneter Frequenz, welches durch den Prüfling (4) hindurch wirkt und dem magnetischen Gleichfeld überlagerbar ist, an den Prüfling (4) angedrückt werden und durch Vibration der Kontaktnadeln (1) einen guten Kontakt zum Prüfling (4) herstellen.

87 P 4453 E

FIG 1

FIG 2

87 P 4453 E

FIG 3

FIG 4

87 P 4453 E

FIG 5

FIG 6

FIG 7

FIG 8

87 P 4453 E

FIG 9

FIG 10

87 P 4453 E

FIG 11

FIG 12

87 P 4453 E

FIG 13

FIG 14

87 P 4453 E

FIG 15

FIG 16

87 P 4453 E

FIG 17

FIG 18

87 P 4453 E

FIG 19    FIG 20    FIG 21    FIG 22    FIG 23    FIG 24